# EUROPEAN PATENT APPLICATION

(11) **EP 4 006 971 A1**
(43) Date of publication of application: **01.06.2022**
(21) Application number: 20848315.6
(22) Date of filing: 28.06.2020
(51) Int. Cl.: H01L 25/075, H01L 33/48, H01L 33/62

(54) **LIGHT-EMITTING DEVICE PACKAGING MEMBER AND DISPLAY DEVICE**

(30) Priority: 26.07.2019 CN 201921192783 U; 18.09.2019 CN 201921553490 U
(71) Applicant: Quanzhou Sanan Semiconductor Technology Co., Ltd., Quanzhou, Fujian 362343 (CN)
(72) Inventor: LIN, Zhen-duan, Xiamen, Fujian 361009 (CN); LIAO, Yanqiu, Xiamen, Fujian 361009 (CN); XIN, Shuning, Xiamen, Fujian 361009 (CN); WONG, Weng-Tack, Xiamen, Fujian 361009 (CN); SHI, Junpeng, Xiamen, Fujian 361009 (CN); CAO, Aihua, Xiamen, Fujian 361009 (CN); YU, Changchin, Xiamen, Fujian 361009 (CN); LIAO, Chi-wei, Xiamen, Fujian 361009 (CN); HSU, Chen-ke, Xiamen, Fujian 361009 (CN); WU, Zheng, Xiamen, Fujian 361009 (CN); LEE, Chia-en, Xiamen, Fujian 361009 (CN)
(74) Representative: Bals & Vogel Patentanwälte PartGmbB
(86) International application number: PCT/CN2020/098501
(87) International publication number: WO 2021/017711

(57) **Abstract**

A light-emitting diode packaging component (100), comprising: a plurality of LED chips (2101) that are spaced apart from each other, the LED chips (2101) comprising a first surface and second surface that are opposite one another, as well as a side surface between the first surface and the second surface, the first surface being a light-emitting surface; a circuit layer that is formed under the second surfaces of the LED chips (2101) and that has a top surface and bottom surface that are opposite one another, as well as a side surface between the top surface and the bottom surface, the top surface being electrically connected to electrodes (2102) of the LED chips (2101); a first packaging layer (2201) coating the side surfaces of the LED chips (2101); and a second packaging layer (2202) coating the side surface of the circuit layer and filling a gap inside of the circuit layer. By defining the thickness of the LED chips (2101) as T_{A}, the thickness of the first packaging layer (2201) as TB, and the thickness of the circuit layer as T_{C}, T_{A} and T_{B} satisfy the relationship: T_{B}/T_{A}**≥**1.

## Description

### RELATED APPLICATION

This application claims priority to Chinese Utility Model Patent Application No. 201921553490.2, entitled "LIGHT-EMITTING DIODE PACKAGING DEVICE AND DISPLAY APPARATUS" and filed on September 18, 2019; and Chinese Utility Model Patent Application No. 201921192783.2, entitled "LIGHT-EMITTING DIODE PACKAGING DEVICE" and filed on July 26, 2019, the entire contents of which are incorporated herein by reference.

### TECHNICAL FIELD

The present invention relates to a light-emitting device package and a light-emitting device using the light-emitting device packaging device.

### BACKGROUND

Light-emitting diodes (LEDs) are one of the most popular light source technologies nowadays, may be used as light sources of lighting devices, and may also be used as light sources of various electronic products. For example, the LEDs are widely used as light sources of various display apparatuses such as TVs, cellular phones, PCs, notebook PCs and personal digital assistants (PDAs). Display resolution may be improved by reducing a size of an LED device, so as to expand application fields of LED display screens, such as mobile phones, vehicle-mounted panels, televisions, computers and video conferencing.

In the market of display screens, small-sized RGB LEDs have grown rapidly and occupy more and more market shares. The small-sized RGB LEDs bring an extremely high pixel experience to the display screens. However, at the same time, the small-sized RGB LEDs also bring great challenges in terms of manufacturing processes. That is, due to their greater thicknesses, thicknesses and application fields of application products are limited. In the related art, RGB chips are fixed mainly to a substrate. Face-up chips require wire bonding or inversion of solder paste, flip chips require solder paste, and vertical chips also require wire bonding. In this way, a packaging thickness is determined by the substrate, the solder paste or wire bonding and thicknesses of the chips, so that the packaging thickness may generally be greater than 500 µm, which is not conducive to thinness and integration of packaging devices. At the same time, due to miniaturization of the size, selection of materials such as solder paste on a packaging end, efficiency and yield of die bonding precision are closely related to costs. Each link faces technical difficulties. Further, the display screens have high requirements on picture quality and a display effect, while treatment processes of packaging surfaces vary, and light color differences exist between pixels, which is easy to lead to light mixing inconsistency and high difficulty of correction, thereby affecting a high-quality display effect.

### SUMMARY

### Technical Problem

### Technical Solution

An objective of the present invention is to provide a light-emitting diode packaging device capable of overcoming at least one shortcoming of the prior art.

According to a first aspect of the present invention, a light-emitting diode packaging device is provided, including: a plurality of LED chips separated from each other, the LED chip including a first surface and a second surface opposite to each other and side surfaces between the first surface and the second surface, the first surface being a light emitting surface; a circuit layer formed under the second surface of the LED chip and having an upper surface and a lower surface opposite to each other and side surfaces between the upper surface and the lower surface, the upper surface being connected to an electrode of the LED chip; a first packaging layer covering the side surfaces and the second surface of the LED chip; and a second packaging layer covering the side surfaces of the circuit layer, and filling a gap inside the circuit layer; a thickness of the LED chip is defined as T_{A}, a thickness of the first packaging layer as T_{B}, and a thickness of the circuit layer as T_{C}, and T_{A} and T_{B} satisfying a relation of T_{B}/T_{A}≥1.

Preferably, the thickness T_{A} of the LED chip ranges from 40 µm to 100 µm, the thickness T_{B} of the first packaging layer ranges from 120 µm to 200 µm, and the thickness T_{C} of the circuit layer ranges from 20 µm to 200 µm.

Preferably, T_{A}, T_{B} and T_{C} satisfy a relation of (T_{B} + T_{C})/T_{A}≤10.

Preferably, T_{A}, T_{B} and T_{C} satisfy a relation of (T_{B} + T_{C})/T_{A}≥1.4.

Preferably, the thickness T_{A} of the LED chip ranges from 5 µm to 10 µm, the thickness T_{B} of the first packaging layer ranges from 80 µm to 100 µm, and the thickness T_{C} of the circuit layer ranges from 20 µm to 200 µm.

Preferably, T_{A}, T_{B} and T_{C} satisfy a relation of (T_{B} + T_{C})/T_{A}≥10.

Preferably, T_{A}, T_{B} and T_{C} satisfy a relation of (T_{B} + T_{C})/T_{A}≤60.

Preferably, the first packaging layer further includes a third packaging layer.

Preferably, the second packaging layer further includes a fourth packaging layer.

Preferably, the first packaging layer is made of a material the same as the second packaging layer.

Preferably, the LED chip is a Mini LED chip or a Micro LED chip.

Preferably, the plurality of LED chips include a plurality of LED chips with different wavelengths.

Preferably, the second surface of the LED chip is provided with a pair of electrodes.

According to the light-emitting diode packaging device, the first packaging layer fixes the LED chip, a circuit connection is then formed, and a package is formed by filling with the second packaging layer. This manner requires no solder wire, thereby improving reliability and contrast ratio. The LED chip requires no soldering of solder paste, preventing poor soldering of the chip and meltback of secondary reflow caused by soldering of the solder paste, which realizes a smaller and thinner package size at the same time and may achieve higher integration.

According to a second aspect of the present invention, a light-emitting diode packaging device is provided, including:
a plurality of LED chips separated from each other, each of the LED chips including a first surface and a second surface opposite to each other and side surfaces, the first surfaces of the plurality of LED chips being on a same side and acting as light emitting surfaces, and the second surface being provided with a pair of electrodes;
a circuit layer located on a second surface side of the LED chip and including a first surface and a second surface opposite to each other and side surfaces, the first surface of the circuit layer being connected to the pair of electrodes of the plurality of LED chips; and
a packaging layer covering the side surfaces of the plurality of LED chips and the side surfaces of the circuit layer and filling gaps between the side surfaces of the plurality of LED chips and gaps between the side surfaces of the circuit layer, the packaging layer having a first surface and a second surface opposite to each other, the first surface of the packaging layer and the first surfaces of the plurality of LED chips being located on a same surface side, and the second surface of the packaging layer and the second surface of the circuit layer facing a same surface side; at least two of the plurality of LED chips have different light radiation ranges, a horizontal height difference between the first surfaces of the at least two LED chips is greater than 0 µm and less than or equal to 10 µm, and the first surface of the packaging layer and a first surface side of the LED chip are further covered with a light transmissive layer.

Preferably, the first packaging layer has a light absorbing component.

Preferably, at least two packaging layers are provided, and the packaging layers between the side surfaces of at least a plurality of chips have light absorbing components.

Preferably, at least two packaging layers are provided, and light transmissivity of the packaging layers between the side surfaces of the plurality of chips is no greater than that of other layers.

Preferably, a plurality of packaging layers are provided, and light transmissivity of the packaging layer covering the circuit layer is greater than that of the packaging layer covering the chip.

Preferably, the circuit layer includes no soldering layer or no soldering layer is provided between the circuit layer and the LED chip.

Preferably, each of the LED chips includes a transparent substrate, the transparent substrate includes a first surface side and a second surface side opposite to each other, the first surface side is a light emitting surface of the LED chip, the second surface side includes a light-emitting semiconductor stack, the light-emitting semiconductor stack includes a first semiconductor layer, a light-emitting layer and a second semiconductor layer, the LED chip further includes two electrodes, and the two electrodes are located on a same side of the light-emitting semiconductor stack.

Preferably, the horizontal height difference between the first surfaces of the at least two LED chips is greater than 0 µm and less than 5 µm.

Preferably, the plurality of chips are three chips in RGB. More preferably, a height of a light emitting surface of the blue chip is lower than heights of light emitting surfaces of other chips based on the second surface of the packaging layer. More preferably, a height of a light emitting surface of the red chip is lower than heights of light emitting surfaces of other chips based on the second surface of the packaging layer.

Preferably, the light transmissive layer includes a light dispersive material.

Preferably, the light transmissive layer has a light transmittance ranging from 40% to 80%.

Preferably, the light transmissive layer has a light transmittance more than 80%.

Preferably, the packaging device has an overall thickness ranging from 100 µm to 500 µm.

Preferably, the light transmissive layer has a thickness ranging from 5 µm to 20 µm.

Preferably, the second surface of the packaging layer and the second surface of the circuit layer face a same surface side.

Preferably, the light-emitting diode packaging device further includes at least two pads formed on the second surface of the packaging layer and connected to the second surface of the circuit layer.

### Beneficial Effect of the Present Invention

### Beneficial Effect

The light-emitting diode packaging device has at least the following beneficial effects.
(1) The package has no substrate, and the LED chip requires no soldering of solder paste, which prevents problems of poor soldering of the chip and meltback of secondary reflow caused by soldering of the solder paste, realizes a smaller and thinner package size at the same time, and may achieve higher integration.
(2) A plurality of chips in different radiation ranges are set to have different height differences in the light emitting surface, which, combined with partial absorption of light brightness of the chips in different radiation ranges by the thinner light transmissive layer of the light emitting surface, realizes fine tuning of the brightness, so as to realize final light emitting proportion requirements of LEDs in different radiation ranges, thereby meeting light color consistency of RGB display applications.
(3) First light emitting surfaces of the plurality of chips are controlled to be less than 10 µm, and the packaging layer helps to unify the light emitting surfaces, so as to reduce the influence of light crosstalk between side surfaces.

Other features and advantages of the present invention will be set forth in part in the specification which follows and in part will become apparent from the specification or may be learned from practice of the present invention. The objectives and other advantages of the present invention may be realized and attained by the structure particularly pointed out in the specification, claims and the accompanying drawings.

### BRIEF DESCRIPTION OF THE DRAWINGS

### Description of the Drawings

The accompanying drawings are intended to provide further understanding of the present invention, and constitute a part of the specification and are used to explain the present invention together with embodiments of the present invention, instead of constituting limitations on the present invention. In addition, data in the drawings is an overview of descriptions, which is not drawn to scale.
FIG 1 and FIG. 2 are perspective views illustrating a structure of an LED packaging device according to some embodiments.
FIG. 3 is a side sectional view illustrating a structure of an LED packaging device according to some embodiments.
FIG. 4 is a side sectional view illustrating a conventional flip LED chip of an LED packaging device according to some embodiments.
FIG. 5 is a perspective view illustrating a LED packaging device according to a variant embodiment of the present invention.
FIG. 6 is a partial side sectional view of the structure of FIG. 5.
FIG. 7 is a plan view illustrating a display panel according to some embodiments.
FIG. 8, FIG. 9 and FIG. 11 are a partial side sectional view illustrating a step of manufacturing an LED packaging device according to some embodiments.
FIG. 10 and FIG. 12 are a partial plan view illustrating a step of manufacturing an LED packaging device according to some embodiments.
FIG. 13 is a schematic perspective view illustrating a step of manufacturing an LED packaging device according to some embodiments.
FIG. 14 is a side sectional view illustrating a structure of an LED packaging device according to some embodiments.
FIG. 15 is a side sectional view illustrating a structure of an LED packaging device according to some embodiments.
FIG. 16 is a side sectional view illustrating a structure of an LED packaging device according to some embodiments.

### DETAILED DESCRIPTION OF THE EMBODIMENTS

### Embodiments of the Present Invention

Embodiments disclose a substrate-free LED packaging device. A plurality of LED chips of the packaging device separated from each other are directly fixed and packaged by a packaging layer, and a circuit layer is formed in the packaging layer.

In some embodiments, the packaging device is very suitable for display panels. In this case, on the one hand, a size of the packaging device can be reduced as much as possible, which is very important to improve resolution of the display panel. On the other hand, a ratio of a light-emitting area of an LED may be significantly reduced, which is very conducive to improving the contrast of the display panel. The ratio of the area is less than 30%, preferably less than 15% or even less than 5%, which may be, for example, 8.5%, 2.8%, or 1.125%, or even lower.

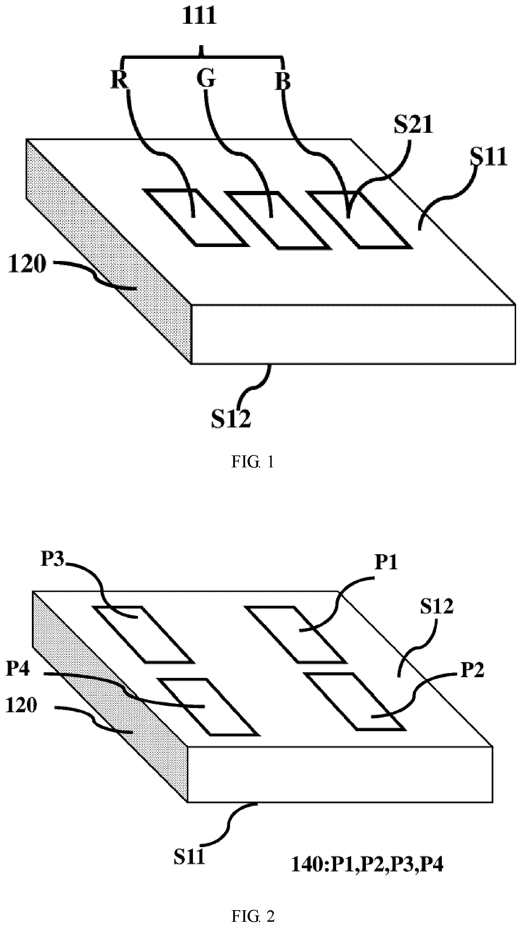

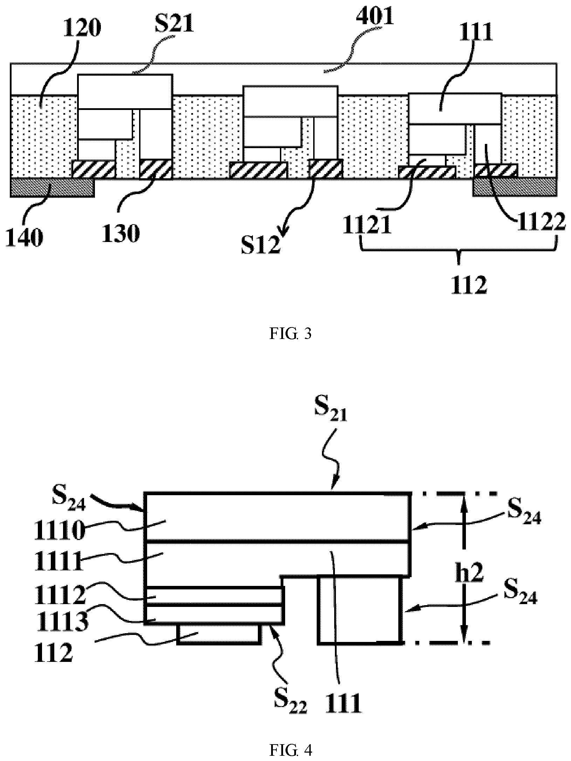

FIG. 1 to FIG. 3 are perspective views and longitudinal cross-sectional views of a light-emitting diode (LED) packaging device 100 according to some exemplary embodiments respectively. The LED packaging device 100 includes a plurality of LED chips 111 separated from each other, a packaging layer 120, a circuit layer 130 and a pad 140. Each of the LED chips 111 has a pair of electrodes 112 located on a same side as shown in FIG. 4.

As shown in FIG. 3, the circuit layer 130 has a first surface, a second surface and side surfaces, the first surface of the circuit layer is connected to the electrodes 112 of the LED chips 111, the packaging layer 120 fixes the plurality of LED chips 111, covers the side surfaces of the LED chips and the side surfaces of the circuit layer 130, and fills gaps between the side surfaces of the LED chips 111 and gaps between the side surfaces of the circuit layer 130, at least part of the second surface of the circuit layer 130 is exposed, and the pad 140 is connected to the circuit layer 130. The circuit layer 130 has functions of connecting the electrodes of the plurality of LED chips 111 in series or parallel within the packaging layer and providing at least part of the second surface exposed from the packaging layer 120, so as to provide an external electrical connection or manufacture a pair of pads on the second surface of the circuit layer 130 to provide an external electrical connection.

The packaging layer 120 has a first surface S11 and a second surface S12 opposite to each other. As shown in FIG. 1, the first surface S11 of the packaging layer 120 and first surfaces S21 of the plurality of LED chips are located on a same surface side, and the second surface S12 of the packaging layer 120 is flush with the second surface of the circuit layer 130.

Specifically, the LED packaging device 100 may include three LED chips. For example, the first LED chip is a blue chip B, the second LED chip is a green chip G, and the third LED chip is a red chip R. For ease of illustration, the LED package device 100 shown in FIG. 1 and FIG. 2 includes three LED chips R, G and B. The three LED chips R, G and B may emit light in different radiation ranges, such as red light, green light and blue light respectively. In order to reduce a size of the packaging device as much as possible, a distance between the LED chips is preferably less than 100 µm, which may, for example, in a range from 50 µm to 100 µm, or even be less than 50 µm. In some applications of display panels, the distance between the LED chips is less than 50 µm, such as ranging from 40 µm to 50 µm, 30 µm to 40 µm, 20 µm to 30 µm, or 10 µm to 20 µm. The smaller the distance, the smaller the size of the packaging device, thereby improving the resolution of the display panels. In some applications of lighting, reduction of the distance between the chips may increase a ratio of an area of the chips to an area of the packaging device.

As shown in FIG. 4, the LED chip 111 may be a general flip LED chip and has a first surface S21 and a second surface S22 opposite to each other, and side surfaces S24. The first surface S21 is a light emitting surface. The second surface S22 is provided with a pair of electrodes 112. The electrode 112 includes a first electrode 1121 electrically connected to a first semiconductor layer 1111 and a second electrode 1122 electrically connected to a second semiconductor layer 1113. The LED chip 111 includes a semiconductor light-emitting stack. The semiconductor light-emitting stack includes the first semiconductor layer 1111, an active layer 1112 and the second semiconductor layer 1113. The first semiconductor layer 1111 and the second semiconductor layer 1113 may be a p-type semiconductor layer and an n-type semiconductor layer respectively. For example, the first semiconductor layers and the second semiconductor layers of the blue LED chip and the green LED chip may be formed by a nitride semiconductor expressed by a chemical formula AlxInyGa(1-x-y)N (where 0≤x≤1, 0≤ y≤1, 0≤x+y≤1), and the first semiconductor layer and the second semiconductor layer of the red LED chip may be formed by a phosphide semiconductor expressed by a chemical formula AlzInwGa(1-x-y)P (where 0≤z≤1, 0≤w≤1, 0≤z+w≤1). The active layers 1112 of the blue LED chip and the green LED chip may have a multi-quantum well (MQW) structure in which quantum well layers and quantum barrier layers are stacked alternately. For example, the active layer 1112 may have nitride-based MQW, such as InGaN/GaN or InGaN/AlGaN, but is not limited thereto. Light-emitting bands of the blue and green chips may be adjusted effectively by adjusting a relative content of In or Al or Ga in the active layer. The active layer of the red may be formed by such as a multi-quantum well structure of InGaP/GaP or GaP/AlGaP or AlGaInP/AlGaInP. Light-emitting bands are adjusted by adjusting a relative content of Al or Ga or In.

Further, a transparent rough surface may also be arranged on the light emitting surface S21 of the LED chip to form diffuse reflection and reduce glare. The rough surface may be made of a matte material.

In some embodiments, the LED chip 111 may also include a transparent substrate 1110 located on the light emitting surface. The transparent substrate 1110 is located on a side of the first surface S21 of the LED chip 111 to emit light. An interface between the transparent substrate 1110 and the semiconductor light-emitting stack may also be provided with a pattern or a bonding layer.

As shown in FIG. 3, the circuit layer 130 is connected to the electrodes 112 of the LED chip. The circuit layer 130, on the one hand, connects the three LED chips in series or parallel as required, and on the other hand, guides the electrodes 112 of the LED chip 111 to a region outside the LED chip, to facilitate wiring. Preferably, the circuit layer 130 may include a plurality of circuit layers, and the plurality of circuit layers may be isolated from one another through the packaging layers. In some preferred embodiments, the circuit layer 130 includes at least two circuit layers. The at least two circuit layers 130 may be formed by electroplating or electroless plating, so as to perform wiring inside the packaging layer. According to the design in the present invention, the circuit layer 130 may be made of Cu, CuxW or other conductive metal materials. The circuit layer 130 is obtained by an electroplating or electroless plating process, and directly forms an electrical connection with the LED chip, which eliminates the use of solder paste and requires no eutectic soldering or reflow soldering process. Therefore, no soldering layer is provided between the circuit layer and the pair of electrodes of the LED chip. The soldering layer includes a soldering layer formed between a flip chip and a pad of a packaging substrate by eutectic soldering or reflow soldering, such as a eutectic layer AuSn or a reflow soldering layer specifically. Preferably, a melting point of the material of the circuit layer is preferably above 400°C, which is conducive to improving reliability of the circuit layer.

As shown in FIG. 2 to FIG. 3, the pad 140 is formed on a lower surface S12 of the packaging layer 120 and is connected to the circuit layer 130. The packaging device may be externally provided with a large-sized pad 140 for back-end chip mounting. It is to be mentioned, however, that the pad 140 is not necessarily required. In some embodiments, the plurality of circuit layers 130 may be provided. One of the circuit layers 130 may be directly used as the pad of the packaging device 100 to be connected to a circuit board. In this case, there is no need to additionally arrange the pad 140 on the packaging layer 120. The number of the pad is not limited. A suitable number may be set according to serial and parallel connection relationships between the LED chips. For example, in this embodiment, the three chips are designed to be connected in parallel, and the number of the pad is at least 4.

In some embodiments, the packaging layer 120 is preferably opaque or low light-transmissive. For example, light transmissivity is lower than 30%, such as ranging from 5% to 20%.

In some embodiments, when the packaging device is based on application requirements of the display panels, the packaging layer 120 may be preferably made of epoxy resin or silica or other packaging resin commonly used on a packaging end, is opaque or low light-transmissive, and specifically includes a light absorbing component (not illustrated in the figures). The light absorbing component is arranged at least around the side surfaces of the LED chip or between adjacent LED chips, or further at least around the semiconductor light-emitting stack of the LED or around adjacent semiconductor light-emitting stacks. The light absorbing component may specifically be light absorbing particles dispersed in the epoxy resin or silica used as the packaging layer, such as black particles or carbon powder, or the light absorbing component is black resin. The light absorbing component of the packaging layer being arranged at least around the side surfaces of the LED may prevent light emission from the side surfaces of the LED chip, so that light emission of the LED chip mainly focuses on the light emitting surface or all focuses on the light emitting surface, which reduces light crosstalk or mixing of light between different LED chips in directions of the side surfaces and may increase the contrast of the packaging device.

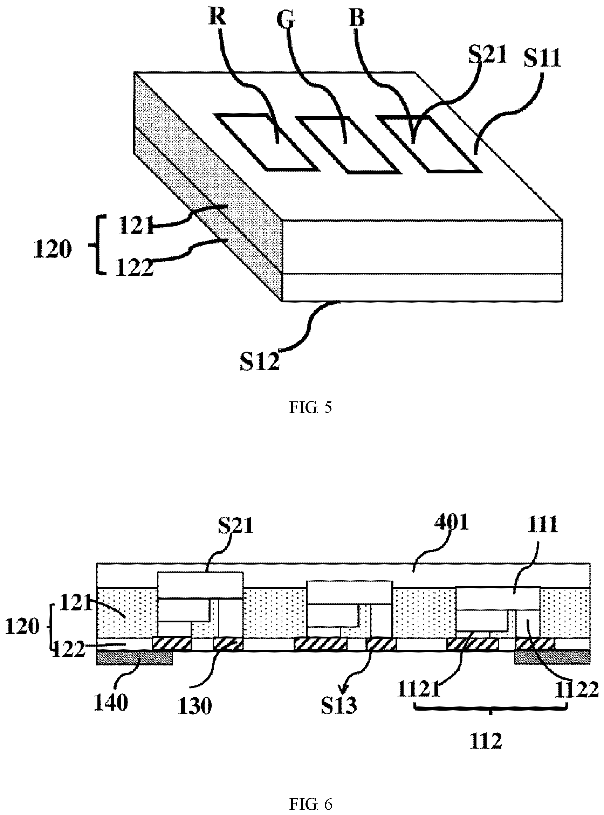

As an implementation, as shown in FIG. 5 to FIG. 6, a plurality of packaging layers 120 are specifically provided. Specifically, at least two packaging layers 120 may be provided. A first packaging layer 121 has a light absorbing component. Specifically, black particles such as carbon powder may be dispersed in the silica or epoxy resin. The first packaging layer 121 covers around the LED chip for sealing the LED chip, and surrounds at least the semiconductor light-emitting stack. A second packaging layer 122 covers a periphery or a gap of the circuit layer 130, or mainly covers the periphery or the gap of the circuit layer, and is configured to seal the circuit layer 130. The second packaging layer 122 is made of a material the same as or different from the first packaging layer 121. The second packaging layer 122 may preferably include no light absorbing component such as carbon powder, and is preferably a light transmissive layer such as silica or epoxy resin, which may ensure reliability of the covering of the circuit layer with the second packaging layer 122. Therefore, the light transmissivity of the second packaging layer 122 is greater than that of the first packaging layer 121.

The LED packaging device 100 integrates the circuit layer 130 in the packaging layer 120, which, on the one hand, requires no wiring bonding or flip chip, and may effectively increase a ratio of an area of the LED chip to an area of the packaging device, and on the other hand, may reduce the number of the pad of the packaging device 100 as much as possible through providing circuit layer, and at the same time, the pad is expanded to a region outside the LED chip on the packaging device to increase a size of a single pad and reduce circuit designs of back-end applications, thereby facilitating back-end chip mounting and simply and effectively reducing the size of the packaging device.

In order to ensure light emitting efficiency of the light emitting surface of the chip and emission of light from the light emitting surface S21 of the LED chip as far as possible so as to control luminous exultance to decrease, the light emitted from the side surfaces of the chip is absorbed by a black adhesive as far as possible, thereby improving the contrast ratio. Therefore, the smaller the difference between heights of the light emitting surfaces S21 of the three LED chips in RGB, the better.

As shown in FIG. 3, as an implementation, a surface of the packaging layer 120 further includes another light transmissive layer 401. The light transmissive layer 401 is configured to seal the first surfaces S21 of the three LED chips. The light transmissive layer 401 may be made of a light-transmissive material such as resin or silica with light transmissivity of at least 40% or ranging from 40% to 80%, or light transmissivity of the light transmissive layer 401 is greater than 80%. The light transmissive layer 400 seals the first surfaces S21 of the three LED chips, which may protect the light emitting surfaces of the LED chips on the one hand, and serve as a light scattering lens to produce a light scattering effect on the other hand, so that an RGB packaging device may effectively reduce dizziness when applied to the display panels finally. Further, the light transmissive layer 401 includes a light dispersive material, such as scattering particles.

According to display application requirements, in this embodiment, the LED chips are chips in different radiation ranges, and may specifically be three RGB chips in different radiation ranges. Further, according to different color temperature requirements of display applications, the three chips are required to be set with appropriate light emission ratios. Generally, three colors (RGB) are difficult to meet absolute requirements of the light emission ratios through a chip process. Therefore, in the present invention, the first light emitting surfaces S21 of the three chips in three colors (RGB) are adjusted to be on different horizontal planes, that is, the first light emitting surfaces have some horizontal height differences, and the surfaces are combined with a light transmissive layer to serve as an optical lens to partially absorb or scatter light, so as to achieve an effect of adjusting the light emission ratios of the chips in different radiation ranges, thereby meeting the color temperature requirements of RGB display applications. Preferably, the height difference is less than 10 µm and greater than 0 µm. A too high height difference may lead to light crosstalk from the side surfaces between adjacent chips. Preferably, based on the second surface S21 of the packaging layer 120, in the three RGB chips, a height of a light emitting surface of the blue chip is lower than a height of a light emitting surface of the green chip, and a height of the light emitting surface of the green chip is lower than a height of a light emitting surface of the red chip. As an implementation, based on the height of the light emitting surface of the blue chip, a difference between the height of the light emitting surface of the red chip and the height of the light emitting surface of the blue chip is about 5 µm, and a difference between the height of the light emitting surface of the green chip and the height of the light emitting surface of the blue chip is about 1 µm. A thickness of the light transmissive layer 401 should be greater than a range of the height differences between the light emitting surfaces of the three chips, and the light transmissive layer 401 completely covers the light emitting surfaces of the three chips. In this implementation, the thickness of the light transmissive layer 401 is preferably 10 µm, and the surface of the blue chip is flush with the first surface of the packaging layer.

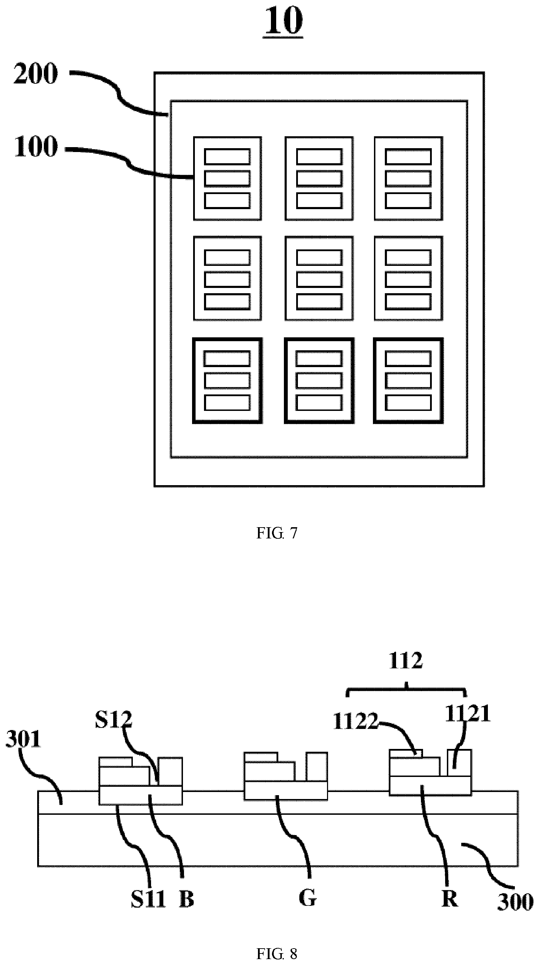

FIG. 7 simply illustrates a plan view of a display panel 10 of the LED packaging device 100 according to an exemplary embodiment.

The display panel 10 may include a circuit board 200 and a plurality of LED packaging devices 100 arranged on the circuit board. They selectively emit red light, green light, and blue light respectively. Each of the plurality of LED packaging devices 100 may construct a single pixel of the display panel, and the plurality of LED packaging devices 100 may be arranged in multiple rows and multiple columns on the circuit board 200.

The three LED chips in the LED packaging device 100 correspond to subpixels of RGB light sources. Radiation ranges of the subpixels are not limited to RGB. In the plurality of LED packaging devices 100, the packaging layer is preferably made of epoxy resin or silica into which black particles are added. In this way, the entire LED packaging device 100 is black except the light emitting surfaces S21 of the LED chips, which helps to improve the contrast ratio of the display panel. At the same time, the LED chips are separated by the black packaging material, which may reduce optical interference with the LED chips. When the LED packaging device 100 shown in FIG. 1 or FIG. 5 is used as a single pixel, a pixel pitch of the display panel may be less than 1 mm.

A flow of manufacturing an LED packaging device is detailed below with reference to FIG. 8 to FIG. 13.

As shown in FIG. 8, three LED chips in RGB are provided. The LED chip 100 has a first surface and a second surface opposite to each other and side surfaces between the first surface S11 and the second surface S12. A pair of electrodes is distributed on the second surface S12. The LED chips are arranged, and the electrodes 112 of all the LED chips are located on a same side, as shown in FIG. 8. The electrodes 112 of the LED chips in the embodiment shown in FIG. 8 are arranged upward, and the LED chips are chips in three colors (RGB). Light-emitting surfaces of three different RGB chips are uniformly fixed to a substrate 300. The substrate 300 is provided with an adhesive layer 301. The first surface S11 of the chip faces the adhesive layer 301 so that the first surfaces S11 of the three LED chips face a same surface side.

Upon application of suitable pressure, the three RGB chips produce different elastic variations on a surface of the adhesive layer 301. Preferably, a thickness of the adhesive layer 301 is less than or equal to 10 µm, so as to control a height difference between light emitting surfaces of the three chips within a range of 0 µm to 10 µm. The adhesive layer 301 may be made of pyrolytic glue or photodegradable glue, and a double-sided adhesive tape is more preferred.

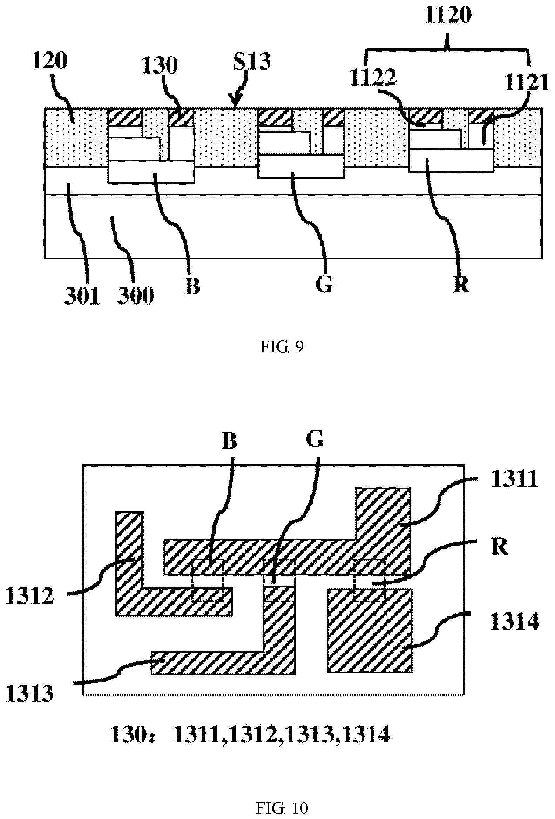

As shown in FIG. 9, packaging layers 120 and circuit layers 130 are formed on side surfaces of the three LED chips 111, and the packaging layers 120 fill gaps between the side surfaces of the LED chips and seal the circuit layers 130, so as to fixedly connect the three LED chips 111 together and a surface of the circuit layer 130 is exposed.

Further, the packaging layers 120 cover the side surfaces of the three LED chips 111, with upper surfaces S13 flush with upper surfaces S23 of the circuit layers of the LED chips. In some embodiments, firstly, the gaps may be filled with the packaging layers 120 by hot press molding to cover electrode surfaces of the three LED chips beyond a certain thickness. The electrode surfaces and connection channels of the chips are exposed by a pattern opening process to manufacture the circuit layers 130. The circuit layer 130 may be an electroplated or electrolessly plated metal layer.

Further, in this embodiment, the RGB chips are connected in parallel, and the circuit layer 130 is designed as shown in FIG. 10. The circuit layer 130 includes at least four parts 1311, 1312, 1313 and 1314. The part 1311 of the circuit layer connects one electrode of the three LED chips, and the remaining three parts connect the remaining electrodes of the three chips respectively. In some preferred embodiments, the circuit layer 130 includes a structure with more than two layers, and the circuit layers have different patterns. The circuit layer 131 is formed by a plurality of subcircuits. Each subcircuit is at least connected to one electrode of the LED chip 111 and extends to a surface of the first packaging layer 121 outside the electrode of the LED chip.

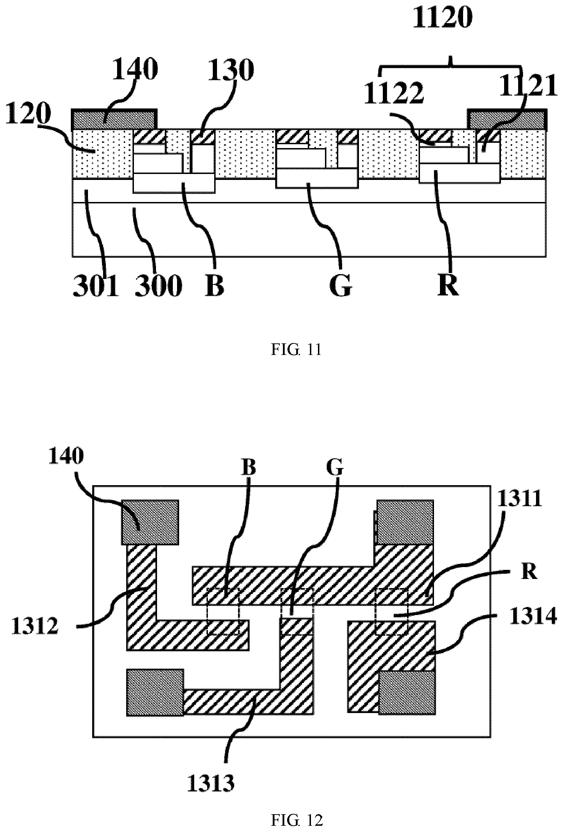

As shown in FIG. 11 to FIG. 13, a pad 140 is manufactured on the surface S12 of the packaging layer 122. The pad 140 forms an electrical connection with the circuit layer 130. So far, the packaging layer has sealed the LED chip, and the circuit layer 130 is integrated inside the packaging layer 120. The pad 140 is manufactured on the surface of the packaging layer 120, with a size much larger than the size of the electrode 1120 of the LED chip 111.

After the pad 140 is manufactured, one side of the pad is transferred to another temporary substrate by a transfer process, and the temporary substrate and the adhesive layer on the side of the light emitting surface are removed to expose the light emitting surfaces of the LED chips with unequal horizontal heights.

The sides of the light emitting surfaces of the three chips and the surfaces of the packaging layers may be covered with an additional light transmissive layer 401, which is made of a material such as epoxy resin or silica. The light-transmissive resin layer has a thickness preferably between 5 µm and 20 µm, and the coverage of the light-transmissive resin layer is beyond the first surfaces the three LED chips. Alternatively, a black adhesive is dispensed on the surface of at least one of the chips before the light transmissive layer 401 to reduce brightness of the chip and reduce a light emission dizziness effect, thereby controlling the light emission ratios of the RGB chips.

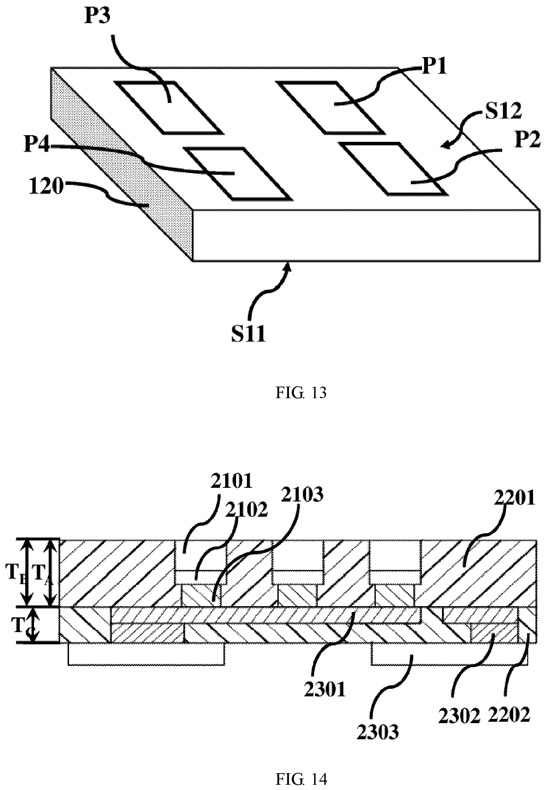

FIG. 14 is a sectional view of a sidewall of a light-emitting diode (LED) packaging device according to some exemplary embodiments. Referring to FIG. 14, the light-emitting diode packaging device includes: a plurality of LED chips 2101 separated from each other, the LED chip including a first surface and a second surface opposite to each other and side surfaces between the first surface and the second surface, the first surface being a light emitting surface; a circuit layer formed under the second surface of the LED chip and having an upper surface and a lower surface opposite to each other and side surfaces between the upper surface and the lower surface, the upper surface being connected to an electrode of the LED chip; a first packaging layer 2201 covering the side surfaces and the second surface of the LED chip; and a second packaging layer 2202 covering the side surfaces of the circuit layer, and filling a gap inside the circuit layer and at least exposing part of the lower surface of the circuit layer. If a thickness of the LED chip 2101 is defined as T_{A}, a thickness of the first packaging layer 2201 as T_{B}, and a thickness of the circuit layer as T_{C}, T_{A} and T_{B} satisfy a relation of T_{B}/T_{A}=1.

The LED chip 2101 may be an LED chip of a conventional size (generally, a size of a single side of the chip is more than 200 µm), or a Mini LED chip (generally, a size of the chip is between 100 µm and 200 µm) or a Micro LED chip (generally, a size of the chip is no more than 100 µm). In this embodiment, the Mini LED chip is preferred.

In this embodiment, the plurality of LED chips include a plurality of LED chips with different wavelengths. Preferably, for example, at least three LED chips emit red light (R), green light (G) and blue light (B) respectively, and an LED chip (including a wavelength conversion layer) emitting white light may also be included, that is, a combination of RGBW is formed, which may improve the brightness of the display screen and is very beneficial for outdoor display.

In this embodiment, the second surface of the LED chip 2101 is provided with a pair of electrodes 2102. Preferably, the LED chip 101 may further include a thickening electrode 2103. The thickening electrode may be formed by electroplating, electroless plating, or printing, and may be made of Cu, CuW or other conductive metal materials. With the arrangement of the thickening electrode, on the one hand, an area of contact between the side surfaces of the LED chip and the first packaging layer 2201 may be increased, so as to increase adhesion between the LED chip and the packaging layer, and on the other hand, the thickening electrode 2103 and the first packaging layer 2201 may form a nail-like structure, so that the LED chip may be better fixed by the packaging layer 120.

In this embodiment, the circuit layer includes a first subcircuit layer 2301, a second subcircuit layer 2302 and a pad 2303. The first subcircuit layer 2301 is configured to electrically connect the plurality of LED chips 2101, which may be connected in series or parallel or connected in series and in parallel. The second subcircuit layer 2302 may be configured to simplify a wiring structure, that is, reduce a number of electrical connection terminals. The pad 2303 is connected to the second subcircuit layer 2302.

The first packaging layer 2121 and the second packaging layer 2122 may be made of a same material or different materials. When made of the same material, the two layers are combined into one layer, and are more difficult to be distinguished from each other. For example, in some embodiments where the LED packaging device is used as a display apparatus, the first and second packaging layers are both made of epoxy resin or silica to which a colorant is added. In this case, the packaging layer fixes and seals the LED chip 2101 on the one hand, and may suppress an optical interference between the LED chips 2101 on the other hand.

In this embodiment, preferably, the thickness T_{A} of the LED chip ranges from 40 µm to 100 µm, the thickness T_{B} of the first packaging layer ranges from 120 µm to 200 µm, and the thickness T_{C} of the circuit layer ranges from 20 µm to 200 µm. More preferably, the thickness T_{C} of the circuit layer ranges from 40 µm to 180 µm, and T_{A}, T_{B} and T_{C} satisfy a relation of 1.4≤(T_{B} + T_{C})/T_{A}≤10. It is to be noted that the number of the circuit layers is at least 2, and 4 circuit layers may also be provided, and each circuit layer has a thickness of 30 µm.

In this embodiment, the first packaging layer fixes the LED chip, a circuit connection is then formed, and a package is formed by filling with the second packaging layer. This manner requires no solder wire, thereby improving reliability and contrast ratio. The LED chip requires no soldering of solder paste, which prevents problems of poor soldering of the chip and meltback of secondary reflow caused by soldering of the solder paste, realizes a smaller and thinner package size at the same time, and may achieve higher integration.

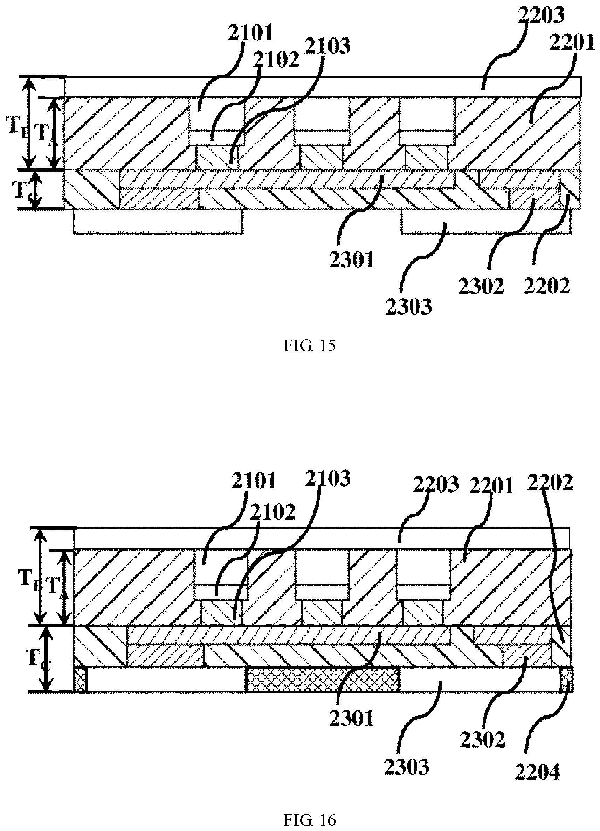

FIG. 15 is a sectional view of a sidewall of a light-emitting diode (LED) packaging device according to some exemplary embodiments. Different from the LED packaging device shown in FIG. 14, the first packaging layer in this embodiment further includes: a third packaging layer 2203. The third packaging layer 2203 covers upper parts of the LED chip 2101 and the second packaging layer, so as to prevent exposure of the LED chip. The third packaging layer is a transparent layer made of silica, resin or the like for example, which may reduce mirror reflection, improve diffuse reflection, and help to improve color unevenness on surfaces of the packaging structure. In addition, in this embodiment, the LED chip 2101 is preferably a Micro LED chip. Preferably, the thickness T_{A} of the LED chip ranges from 5 µm to 10 µm, the thickness T_{B} of the first packaging layer ranges from 80 µm to 100 µm, and the thickness T_{C} of the circuit layer ranges from 20 µm to 200 µm. More preferably, the thickness T_{C} of the circuit layer ranges from 40 µm to 180 µm, and T_{A}, T_{B} and T_{C} satisfy a relation of 10≤(T_{B} + T_{C})/T_{A}≤60, which may prevent too large stress and too great thermal resistance caused by a too thick circuit layer, reduce an overall thickness of the packaging structure while ensuring the strength of the packaging structure, and finally make application products slimmer.

FIG. 16 is a sectional view of a sidewall of a light-emitting diode (LED) packaging device according to some exemplary embodiments. Different from the LED packaging device shown in FIG. 15, the second packaging layer in this embodiment further includes: a fourth packaging layer 2204. The fourth packaging layer 2204 is configured to fill up a gap between the pads 2303, and may be made of an insulating material or epoxy resin or solder resist ink, or any combination thereof. It is to be noted that when the fourth packaging layer is filled between the pads 2303, the pads may also be considered as a consisting part of the circuit layer. That is, the thickness T_{C} of the circuit layer includes an overall thickness of the first subcircuit layer 2301, the second subcircuit layer 2302 and the pad 2303.

As described above, the present invention is specifically described according to the embodiments with reference to the accompanying drawings. However, the embodiments are only illustrative of preferred examples of the present invention. Therefore, the present invention shall not be understood as being limited only to the embodiments, and the present invention shall be understood as technical solutions of the present invention and equivalent concepts thereof.

## Claims

1. A light-emitting diode packaging device, comprising:
a plurality of LED chips separated from each other, the LED chip comprising a first surface and a second surface opposite to each other and side surfaces between the first surface and the second surface, the first surface being a light emitting surface;
a circuit layer formed under the second surface of the LED chip and having an upper surface and a lower surface opposite to each other and side surfaces between the upper surface and the lower surface, the upper surface being connected to an electrode of the LED chips;
a first packaging layer covering the side surfaces and the second surface of the LED chip; and
a second packaging layer covering the side surfaces of the circuit layer, and filling a gap inside the circuit layer;
wherein a thickness of the LED chip is defined as T_{A}, a thickness of the first packaging layer as T_{B}, and a thickness of the circuit layer as T_{C}, and T_{A} and T_{B} satisfying a relation of T_{B}/T_{A}≥1.

2. The light-emitting diode packaging device according to claim 1, wherein the thickness T_{A} of the LED chip ranges from 40 µm to 100 µm, the thickness T_{B} of the first packaging layer ranges from 120 µm to 200 µm, and the thickness T_{C} of the circuit layer ranges from 20 µm to 200 µm.

3. The light-emitting diode packaging device according to claim 2, wherein T_{A}, T_{B} and T_{C} satisfy a relation of (T_{B} + T_{C})/T_{A}≤10.

4. The light-emitting diode packaging device according to claim 2, wherein T_{A}, T_{B} and T_{C} satisfy a relation of (T_{B} + T_{C})/T_{A}≥1.4.

5. The light-emitting diode packaging device according to claim 1, wherein the thickness T_{A} of the LED chip ranges from 5 µm to 10 µm, the thickness T_{B} of the first packaging layer ranges from 80 µm to 100 µm, and the thickness T_{C} of the circuit layer ranges from 20 µm to 200 µm.

6. The light-emitting diode packaging device according to claim 5, wherein T_{A}, T_{B} and T_{C} satisfy a relation of (T_{B} + T_{C})/T_{A}≥10.

7. The light-emitting diode packaging device according to claim 5, wherein T_{A}, T_{B} and T_{C} satisfy a relation of (T_{B} + T_{C})/T_{A}≤60.

8. The light-emitting diode packaging device according to claim 1, wherein the first packaging layer further comprises a third packaging layer.

9. The light-emitting diode packaging device according to claim 1, wherein the second packaging layer further comprises a fourth packaging layer.

10. The light-emitting diode packaging device according to claim 1, wherein the first packaging layer is made of a material the same as the second packaging layer.

11. The light-emitting diode packaging device according to claim 1, wherein the LED chip is a Mini LED chip or a Micro LED chip.

12. The light-emitting diode packaging device according to claim 1, wherein the plurality of LED chips comprise a plurality of LED chips with different wavelengths.

13. The light-emitting diode packaging device according to claim 1, wherein the second surface of the LED chip is provided with a pair of electrodes.

14. The light-emitting diode packaging device according to claim 1, wherein the first packaging layer has a first surface and a second surface opposite to each other, the first surface and the first surfaces of the plurality of LED chips are located on a same surface side, at least two LED chips of the plurality of LED chips have different light radiation ranges, a horizontal height difference between the first surfaces of the at least two LED chips is greater than 0 µm and less than or equal to 10 µm, the first surface and a first surface side of the LED are further covered with a light transmissive layer, and the packaging layer comprises a light absorbing component.

15. The light-emitting diode packaging device according to claim 1 or 14, wherein the first packaging layer has a light absorbing component.

16. The light-emitting diode packaging device according to claim 1 or 14, wherein light transmissivity of the first packaging layer is no greater than that of the second packaging layer.

17. The light-emitting diode packaging device according to claim 1 or 14, wherein the circuit layer comprises no soldering layer or no soldering layer is provided between the circuit layer and the LED chip.

18. The light-emitting diode packaging device according to claim 1 or 14, wherein each of the LED chips comprises a transparent substrate, the transparent substrate comprises a first surface side and a second surface side opposite to each other, the first surface side of the transparent substrate is a light emitting surface of the LED chip, the second surface side of the transparent substrate comprises a light-emitting semiconductor stack, the light-emitting semiconductor stack comprises a first semiconductor layer, a light-emitting layer and a second semiconductor layer, the LED chip further comprises two electrodes, and the two electrodes are located on a same side of the light-emitting semiconductor stack.

19. The light-emitting diode packaging device according to claim 1 or 14, wherein the horizontal height difference between the first surfaces of the at least two LED chips is greater than 0 µm and less than 5 µm.

20. The light-emitting diode packaging device according to claim 1 or 14, wherein the plurality of chips are three chips in RGB.

21. The light-emitting diode packaging device according to claim 20, wherein a height of a light emitting surface of the blue chip is lower than heights of light emitting surfaces of other chips based on the second surface of the packaging layer.

22. The light-emitting diode packaging device according to claim 20, wherein a height of a light emitting surface of the red chip is lower than heights of light emitting surfaces of other chips based on the second surface of the packaging layer.

23. The light-emitting diode packaging device according to claim 14, wherein the light transmissive layer comprises a light dispersive material.

24. The light-emitting diode packaging device according to claim 14, wherein the light transmissive layer has a light transmittance ranging from 40% to 80%.

25. The light-emitting diode packaging device according to claim 14, wherein the light transmissive layer has a light transmittance more than 80%.

26. The light-emitting diode packaging device according to claim 14, wherein the light transmissive layer has a thickness ranging from 5 µm to 20 µm.

27. The light-emitting diode packaging device according to claim 1 or 14, wherein the packaging device has an overall thickness ranging from 100 µm to 500 µm.

28. The light-emitting diode packaging device according to claim 1 or 14, further comprising at least two pads formed on a surface of the second packaging layer and connected to the second surface of the circuit layer.

29. A light-emitting diode packaging device, comprising:
a plurality of LED chips separated from each other, each of the LED chips comprising a first surface and a second surface opposite to each other and side surfaces, the first surfaces of the plurality of LED chips being on a same side and acting as light emitting surfaces, and the second surface being provided with a pair of electrodes;
a circuit layer located on a second surface side of the LED chip and comprising a first surface and a second surface opposite to each other and side surfaces, the first surface of the circuit layer being connected to the pair of electrodes of the plurality of LED chips; and
a packaging layer covering the side surfaces of the plurality of LED chips and the side surfaces of the circuit layer and filling gaps between the side surfaces of the plurality of LED chips and gaps between the side surfaces of the circuit layer, the packaging layer having a first surface and a second surface opposite to each other, the first surface of the packaging layer and the first surfaces of the plurality of LED chips being located on a same surface side, and the second surface of the packaging layer and the second surface of the circuit layer facing a same surface side, wherein at least two of the plurality of LED chips have different light radiation ranges, a horizontal height difference between the first surfaces of the at least two LED chips is greater than 0 µm and less than or equal to 10 µm, and the first surface of the packaging layer and a first surface side of the LED chip are further covered with a light transmissive layer.

30. The light-emitting diode packaging device according to claim 29, wherein the packaging layer comprises a light absorbing component.

31. The light-emitting diode packaging device according to claim 29, wherein at least two packaging layers are provided, and wherein at least the packaging layers between the side surfaces of a plurality of chips have light absorbing components.

32. The light-emitting diode packaging device according to claim 29, wherein at least two packaging layers are provided, and wherein light transmissivity of the packaging layers between the side surfaces of the plurality of chips is no greater than that of other layers.

33. The light-emitting diode packaging device according to claim 29, wherein a plurality of packaging layers are provided, wherein light transmissivity of the packaging layer covering the circuit layer is greater than that of the packaging layer covering the chip.

34. The light-emitting diode packaging device according to claim 29, wherein the circuit layer comprises no soldering layer or no soldering layer is provided between the circuit layer and the LED chip.

35. The light-emitting diode packaging device according to claim 29, wherein each of the LED chips comprises a transparent substrate, the transparent substrate comprises a first surface side and a second surface side opposite to each other, the first surface side of the transparent substrate is a light emitting surface of the LED chip, the second surface side of the transparent substrate comprises a light-emitting semiconductor stack, the light-emitting semiconductor stack comprises a first semiconductor layer, a light-emitting layer and a second semiconductor layer, the LED chip further comprises two electrodes, and the two electrodes are located on a same side of the light-emitting semiconductor stack.

36. The light-emitting diode packaging device according to claim 29, wherein the horizontal height difference between the first surfaces of the at least two LED chips is greater than 0 µm and less than 5 µm.

37. The light-emitting diode packaging device according to claim 29, wherein the plurality of chips are three chips in RGB.

38. The light-emitting diode packaging device according to claim 37, wherein a height of a light emitting surface of the blue chip is lower than heights of light emitting surfaces of other chips based on the second surface of the packaging layer.

39. The light-emitting diode packaging device according to claim 37, wherein a height of a light emitting surface of the red chip is lower than heights of light emitting surfaces of other chips based on the second surface of the packaging layer.

40. The light-emitting diode packaging device according to claim 29, wherein the light transmissive layer comprises a light dispersive material.

41. The light-emitting diode packaging device according to claim 29, wherein the light transmissive layer has a light transmittance ranging from 40% to 80%.

42. The light-emitting diode packaging device according to claim 29, wherein the light transmissive layer has a light transmittance more than 80%.

43. The light-emitting diode packaging device according to claim 29, wherein the packaging device has an overall thickness ranging from 100 µm to 500 µm.

44. The light-emitting diode packaging device according to claim 29, wherein the light transmissive layer has a thickness ranging from 5 µm to 20 µm.

45. The light-emitting diode packaging device according to claim 29, further comprising at least two pads formed on the second surface of the packaging layer and connected to the second surface of the circuit layer.

46. The light-emitting diode packaging device according to claim 29, wherein the second surface of the packaging layer is flush with the second surface of the circuit layer.

47. A display apparatus, comprising the light-emitting diode packaging device according to any one of claims 1 to 46.
